# EUROPÄISCHE PATENTSCHRIFT

(11) **EP 4 002 040 B1**
(45) Veröffentlichungstag und Bekanntmachung des Hinweises auf die Patenterteilung: **03.05.2023**
(21) Anmeldenummer: 21196402.8
(22) Anmeldetag: 13.09.2021
(51) Int. Cl.: G05B 23/02

(54) **VERFAHREN ZUR ÜBERWACHUNG VON AUF EINER VERFAHRENSTECHNISCHEN ANLAGE MIT MESSGERÄTEN GEMESSENEN MESSGRÖSSEN**
METHOD FOR MONITORING MEASUREMENT VALUES MEASURED ON A TECHNICAL PLANT WITH MEASURING DEVICES
PROCÉDÉ DE SURVEILLANCE DES GRANDEURS DE MESURE MESURÉES À L'AIDE D'UN APPAREIL DE MESURE DANS UNE INSTALLATION TECHNIQUE

(30) Priorität: 19.11.2020 DE 102020130618
(43) Veröffentlichungstag der Anmeldung: 25.05.2022
(73) Patentinhaber: Endress+Hauser Group Services AG, 4153 Reinach (CH)
(72) Erfinder: Malinovskiy, Alexey, 79689 Maulburg (DE); Nick, Markus, 68680 Kembs (FR); Klein, Francois, 68220 Hagenthul de Haut (FR)
(74) Vertreter: Andres, Angelika Maria

(56) Entgegenhaltungen:
- EP-A1- 3 002 651
- WO-A1-2017/085468
- WO-A2-2008/042739
- US-A1- 2012 271 782

## Beschreibung

Die Erfindung betrifft ein Verfahren, insb. ein computerimplementiertes Verfahren, zur Überwachung von auf einer verfahrenstechnischen Anlage während wiederholter Ausführungen eines vorgegebenen dynamischen Prozesses mit einer Gruppe von auf der Anlage eingesetzten Messgeräten fortlaufend gemessenen, sich während der Prozesse zeitlich verändernden Messgrößen.

Verfahrenstechnische Anlagen zur wiederholten Ausführung von vorgegebenen dynamischen Prozessen werden in einer Vielzahl unterschiedlicher Industriezweige, wie z.B. in der Chemie, der Lebensmittelindustrie, sowie oder in der Wasser- und Abwasseraufbereitung eingesetzt. Sie umfassen unter anderem Herstellung-, Verarbeitungs- und Aufbereitungsanlagen. Auf diesen Anlagen werden üblicher Weise Messgeräte eingesetzt, die jeweils mindestens eine für den auszuführenden Prozess und/oder ein mittels des Prozesses erzielbares Prozessprodukt relevante Messgröße messen. Beispiele für derartige Messgeräte sind Druckmessgeräte, Füllstandsmessgeräte, Dichtemessgeräte, Temperaturmessgeräte, Durchflussmessgeräte, pH-Wert Messgeräte etc., wie sie z.B. von der Endress + Hauser Gruppe vertrieben werden. In der Mess- und Regeltechnik, so wie auch in der Prozessautomatisierung werden die Messwerte dieser Messgeräte z.B. dazu eingesetzt, den mittels der Anlage wiederholt auszuführenden Prozess zu überwachen, zu steuern und/oder zu regeln.

Im laufenden Betrieb dieser Anlagen auftretende Anomalien, wie z.B. Fehlfunktionen und/oder Beschädigungen der Anlage, eine fehlerhafte Steuerung und/oder Regelung der Anlage, sowie natürlich auch durch Fehlfunktionen der Messgeräte bedingte fehlerbehaftete Messwerte der Messgrößen können unter Umständen erhebliche Schäden verursachen. Diese reichen von der Produktion fehlerhafter Prozessprodukte bis hin zu von der Anlage und/oder von fehlerhaften Prozessprodukte ausgehenden Gefahren für Mensch und Umwelt.

Um eine einwandfreie Funktion der Anlage und der Messgeräte sicher zu stellen, werden Messgeräte üblicher Weise regelmäßig Servicemaßnahmen unterzogen. Zu diesen Servicemaßnahmen zählen z.B. Verifikationen, Kalibrationen und Wartungen. Da mit diesen Servicemaßnahmen Kosten, sowie ggfs. auch eine Unterbrechung des laufenden Messbetriebs verbunden ist, werden die Zeitabstände zwischen aufeinander folgenden Servicemaßnahmen vorzugsweise derart bemessen, dass sie einerseits kurz genug sind, um ein ausreichendes Maß an Sicherheit zu gewährleisten und andererseits lang genug sind, um Kosten und Aufwand in einem angemessenen Rahmen zu halten. Um die Funktionsfähigkeit von Messgeräten auch innerhalb der Zeiträume zwischen zeitlich aufeinander folgenden Servicemaßnahmen überprüfen zu können, ist es möglich einzelne Messgeräte mit einer zusätzlichen Funktionalität, wie z.B. einer Selbstüberwachungsfunktion oder einer Diagnosefunktion, auszustatten, mittels der das jeweilige Messgerät selbsttätig seine Funktion überwacht. Ein Beispiel hierfür sind von der Endress+Hauser Gruppe angebotene Messgeräte, die mit einer Heartbeat-Funktion ausgestattet sind, mittels der sich das Messgerät selbst überwacht. Diese Messgerät sind jedoch regelmäßig teurer als Messgeräte ohne derartige Funktionalität und werden daher aus Kostengründen in der Regel nur in sicherheitsrelevanten Bereichen eingesetzt.

Alternativ besteht die Möglichkeit die Funktion eines bestimmten Messgeräts anhand eines zu diesem Zweck erstellten Modells zu überwachen, dass die von diesem bestimmten Messgerät gemessene Messgröße als Funktion einer oder mehrerer mittels anderer Messgeräte messbaren Messgrößen beschreibt. Die Aufstellung derartiger Modelle erfordert jedoch regelmäßig detaillierte Kenntnisse des mittels der Anlage auszuführenden Prozesses, sowie der sich daraus ggfs. ergebenden - in der Regel physikalisch bedingten - Abhängigkeiten der einzelnen Messgrößen voneinander.

Darüber hinaus ist in der EP 3 002 651 A1 ein Verfahren zur Überwachung eines Prozessschritts eines mittels einer Anlage ausführbaren Prozesses beschrieben. Die Überwachung des Prozessschritts erfolgt hier anhand von während der Ausführung des Prozessschrittes mit auf der Anlage gemessenen Messwerten von Messgrößen und den zugehörigen auf einen Startzeitpunkt der jeweiligen Durchführung des Prozessschritts bezogenen Messzeiten. Hierzu wird anhand von Trainingsdaten ein Model erstellt, das anhand der Messwerte und der Messzeiten bestimmbare Kenngrößen umfasst. Die Kenngrößen umfassen für mehrere Messgeräte jeweils:
a) anhand der Messwerte des jeweiligen Messgeräts bestimmte Koeffizienten einer die während der Durchführung des Prozessschritts zu erwartenden, die Messwerte als Funktion der Zeit wiedergebenden Basisfunktionen, sowie
b) eine Verteilung der Abweichungen zwischen den Messwerten und einer durch die zuvor bestimmten Koeffizienten und die Basisfunktion gegeben Funktion. Darüber hinaus umfassen sie Korrelationsgrade zwischen den Messwerten von Messgerät-Paaren, die während der Durchführung des Prozessschritts korrelierende Messwerte liefern.

Zusätzlich umfasst das Modell für jede Kenngröße einen zugehörigen anhand der Trainingsdaten bestimmten Referenzbereich, in dem die jeweilige Kenngröße bei fehlerfreier Durchführung des Prozessschritts zu erwarten ist. Entsprechend wird durch das Überwachungsverfahren eine Anomalie erkannt, wenn mindestens eine der während der Überwachung bestimmten Kenngrößen außerhalb des zugehörigen Referenzbereichs liegt.

Dieses Verfahren bietet den Vorteil, dass das Modell einschließlich der Referenzbereiche, sowie auch die Überwachung des Prozessschritts anhand der ohnehin vorhandenen Messwerte durchgeführt werden kann. Nachteilig ist jedoch, dass das Verfahren für jeden einzelnen zu überwachenden Prozessschritt separat durchgeführt werden muss, dass die Messdaten bezogen auf den Startzeitpunkt des jeweiligen Prozessschritts erfasst werden müssen, und vor allem, dass die Erstellung des Modells relativ aufwendig ist.

Die US 2012/271782 A1 zeigt aus Messwerten gebildete Ereignisvektoren mit dazugehöriger Clusteranalyse. Die Schrift zeigt keine zeitlichen Ableitungen der Messwerte vor deren Zusammenfassung zu Vektoren.

Die WO 2008/042739 A2 vergleicht Vektoren aus Prozessvariablen unter Verwendung von Dimensionsreduktion. Die Schrift zeigt keine Referenzcluster.

Die WO 2017/085468 A1 zeigt Messwertereihen, deren zeitliche Ableitungen mit Referenzwerten verglichen werden. Auch zeitliche Mittelwertbildung und Clustering sind im gleichen Zusammenhang erwähnt. Die Schrift zeigt nicht, dass Messwertereihen verschiedener Sensoren zu Vektoren zusammengefasst werden.

Es ist eine Aufgabe der Erfindung ein alternative einsetzbares Verfahren zur Überwachung von auf einer verfahrenstechnischen Anlage während wiederholter Ausführungen eines vorgegebenen dynamischen Prozesses mit einer Gruppe von auf der Anlage eingesetzten Messgeräten fortlaufend gemessenen, sich während der Prozesse zeitlich verändernden Messgrößen, anzugeben, dass ohne detaillierte Kenntnisse des Prozesses auf einfachere Weise durchführbar ist.

Diese Aufgabe wird durch ein Verfahren, insb. ein computerimplementiertes Verfahren, zur Überwachung von auf einer verfahrenstechnischen Anlage während wiederholter Ausführungen eines vorgegebenen dynamischen Prozesses mit einer Gruppe von auf der Anlage eingesetzten Messgeräten fortlaufend gemessenen, sich während der Prozesse zeitlich verändernden Messgrößen, gelöst, bei dem:
während der wiederholten Ausführungen des dynamischen Prozesses fortlaufend Messdaten erfasst werden, die mittels der Messgeräte gemessene Messwerte der Messgrößen und die zugehörigen Messzeiten, zu denen die Messwerte gemessen wurden, umfassen,
wobei die Messdaten in einem Trainingszeitraum gemessene Trainingsdaten und im Anschluss an den Trainingszeitraum gemessene Überwachungsdaten umfassen,
anhand der Messdaten fortlaufend Vektoren bestimmt werden, deren Vektorkomponenten jeweils für eine Reihe von k aufeinander folgenden Zeitpunkten anhand der Messdaten bestimmte Änderungsgeschwindigkeiten der Messwerte der einzelnen Messgrößen umfassen, wobei die Zeitpunkte jeder Reihe jeweils ein Zeitfenster vorgegebener Dauer abdecken und die Zeitfenster aufeinander folgender Vektoren gegeneinander jeweils um eine vorgegebene Zeitdifferenz verschoben sind,
die anhand der Trainingsdaten bestimmten Vektoren in Form eines Referenzclusters erfasst und abgespeichert werden, und
ein Überwachungsverfahren ausgeführt wird, bei dem:
   die anhand der Überwachungsdaten bestimmten Vektoren jeweils mit dem Referenzcluster verglichen werden,
   eine Anomalie festgestellt wird, wenn mindestens einer der anhand der Überwachungsdaten bestimmten Vektoren außerhalb des Referenzcluster liegt, und
   eine Information über die festgestellte Anomalie zur Verfügung gestellt wird.

Das erfindungsgemäße Verfahren bietet den Vorteil, dass es ohne detaillierte Kenntnisse des Prozesses auf einfachere Weise unmittelbar anhand der Messwerte der Messgrößen durchführbar ist. Ein weiterer Vorteil besteht darin, dass über die Vektoren die über den Prozess zeitlich gekoppelten Reaktionsgeschwindigkeiten der Messwerte aller Messgrößen im Verbund in einem der Dauer der Zeitfenster entsprechenden Zeitraum erfasst werden, und die Überwachung aufgrund der gleitenden Zeitfenster der aufeinander folgenden Vektoren über die gesamte Betriebsdauer der Anlage hinweg erfolgen kann. Ein weiterer Vorteil besteht darin, dass die Anomalien unmittelbar anhand des Referenzclusters erkennbar sind und das Referenzcluster anhand der Trainingsdaten auf sehr einfache Weise bestimmbar ist. Das bietet den Vorteil, dass zur Durchführung des Verfahrens weder aufwendige Modelle bestimmt, noch Abhängigkeiten zwischen einzelnen Messgrößen ermittelt werden müssen.

Eine erste Ausgestaltung umfasst ein Verfahren, bei dem:
die Erfassung der Messdaten derart erfolgt, dass die Messwerte der Messgrößen und die zugehörigen Messzeiten an eine Datenverarbeitungseinrichtung übermittelt werden und zumindest vorübergehend in einem der Datenverarbeitungseinrichtung zugeordneten Speicher abgespeichert werden, und
die Datenverarbeitungseinrichtung dazu ausgebildet ist, anhand der Messdaten die Bestimmung der Vektoren, die Bestimmung des Referenzclusters und das Überwachungsverfahren auszuführen, und dazu ausgebildet ist, die Information über die festgestellte Anomalie über eine an die Datenverarbeitungseinrichtung angeschlossene Schnittstelle auszugeben und/oder in über die Schnittstelle auslesbarer und/oder abrufbarer Form zur Verfügung zu stellen.

Eine erste Weiterbildung umfasst ein Verfahren, bei dem die vorgegebene Dauer der Zeitfenster:
kleiner gleich einer Prozessdauer des Prozesses ist,
größer gleich einer Dauer mindestens eines während jeder Durchführung des Prozesses auftretenden dynamischen Prozessereignisses ist, durch das sich mindestens zwei der Messgrößen zeitlich verändern,
größer gleich mindestens einer jeweils einer der Messgrößen zugeordneten Reaktionszeit ist, mit der sich die Messwerte der jeweiligen Messgröße in Reaktion auf ein dynamisches Prozessereignis verändern, und/oder
größer gleich mindestens einer jeweils einer der Messgrößen zugeordneten Zeitskala ist, auf der sich die Messwerte der jeweiligen Messgröße zeitlich verändern.

Eine zweite Weiterbildung umfasst ein Verfahren, bei dem die vorgegebene Dauer der Zeitfenster anhand der Trainingsdaten bestimmt wird, indem:
anhand der Änderungsgeschwindigkeiten der Messwerte einer der Messgrößen ein Startzeitpunkt bestimmt wird, an dem die Änderungsgeschwindigkeiten der Messwerte dieser Messgröße einen vorgegebenen Grenzwert übersteigen,
anhand der Messwerte der anderen Messgrößen für jede der anderen Messgrößen jeweils ein messgrößen-spezifischer Endzeitpunkt bestimmt wird, an dem die Änderungsgeschwindigkeiten der Messwerte der jeweiligen anderen Messgröße nach dem Startzeitpunkt erstmals einen vorgegebenen Grenzwert übersteigen,
für jede Messgröße jeweils eine Differenz zwischen dem messgrößen-spezifische Endzeitpunkt und dem Startzeitpunkt bestimmt wird, und
die Dauer der Zeitfenster derart bestimmt wird, dass sie größer gleich mindestens einer dieser Differenzen ist.

Eine dritte Weiterbildung umfasst ein Verfahren, bei dem die vorgegebene Dauer der Zeitfenster anhand der Trainingsdaten bestimmt wird, indem:
für mindestens eine der Messgrößen jeweils:
anhand der Änderungsgeschwindigkeiten der Messwerte der jeweiligen Messgröße Zeiträume ermittelt werden, in denen sich die Messwerte der jeweiligen Messgröße zeitlich verändern und ein Mittelwert der in diesen Zeiträumen auftretenden Änderungsgeschwindigkeiten bestimmt wird, und
eine Zeitskala bestimmt wird, die einem Zeitraum entspricht, in dem sich die Messwerte dieser Messgröße bei einer dem Mittelwert entsprechenden Änderungsgeschwindigkeit um einen vorgegebenen Anteil, um einem Anteil von größer gleich 40 % oder um einen Anteil von größer gleich 60% eines Messbereichs des die jeweilige Messgröße messenden Messgeräts verändert, und
die Dauer der Zeitfenster derart bestimmt wird, dass sie größer gleich mindestens einer dieser Zeitskalen ist.

Eine vierte Weiterbildung umfasst ein Verfahren, bei dem die Zeitabstände zwischen den innerhalb der Zeitfenster aufeinander folgenden Zeitpunkten jeweils gleich einer vorgegebenen konstanten Diskretisierungszeit sind.

Gemäß einer Weiterbildung der vierten Weiterbildung ist die Diskretisierungszeit derart bemessen ist, dass sie klein genug ist um eine Prozessdynamik des Prozesses auflösen zu können.

Gemäß einer weiteren Weiterbildung der vierten Weiterbildung wird die Diskretisierungszeit anhand der Trainingsdaten bestimmt, indem:
für mindestens eine der Messgrößen jeweils:
anhand der Änderungsgeschwindigkeiten der Messwerte der jeweiligen Messgröße Zeiträume ermittelt werden, in denen sich die Messwerte zeitlich verändern und ein Mittelwert der in diesen Zeiträumen auftretenden Änderungsgeschwindigkeiten bestimmt wird, und
eine Zeitskala bestimmt wird, die einem Zeitraum entspricht, in dem sich die Messwerte dieser Messgröße bei einer dem Mittelwert entsprechenden Änderungsgeschwindigkeit um einen vorgegebenen Prozentsatz, um einem Prozentsatz von kleiner gleich 10 % oder um einen Prozentsatz von kleiner gleich 5 % eines Messbereichs des die jeweilige Messgröße messenden Messgeräts verändert, und
die Diskretisierungszeit derart bestimmt wird, dass sie kleiner gleich mindestens einer dieser Zeitskalen ist.

Eine fünfte Weiterbildung umfasst ein Verfahren, bei dem die Zeitdifferenz, um die die Zeitfenster aufeinander folgender Vektoren zeitlich gegeneinander verschoben sind, größer als die Diskretisierungszeit ist und/oder kleiner gleich der Dauer der Zeitfenster ist.

Eine zweite Ausgestaltung umfasst ein Verfahren, bei dem eine Ursache einer durch das Überwachungsverfahren festgestellten Anomalie ermittelt und/oder durch eine entsprechende Gegenmaßnahme behoben wird.

Eine sechste Weiterbildung umfasst ein Verfahren, bei dem für mindestens einen anhand des Überwachungsverfahrens als außerhalb des Referenzclusters liegender Vektor identifizierten Vektor anhand eines Abstands dieses Vektors vom Referenzcluster mindestens eine Anomalieursache ermittelt wird, indem:
für jede Messgröße jeweils ein anteiliger Beitrag der Änderungsgeschwindigkeiten der Messwerte der jeweiligen Messgröße zum Abstand des Vektors vom Referenzcluster bestimmt wird, und
als Anomalieursache die Messwerte derjenigen Messgröße(n) bestimmt werden, deren anteiliger Beitrag den größten Wert aufweist und/oder einen vorgegebenen Grenzwert überschreitet, und
eine Information über die Anomalieursache(n) zur Verfügung gestellt wird.

Gemäß einer Weiterbildung der sechsten Weiterbildung wird anhand mindestens einer der zuvor bestimmten Anomalieursachen eine Ursache der mittels des Überwachungsverfahrens festgestellten Anomalie ermittelt, indem überprüft wird, ob die durch das Überwachungsverfahren detektierte Anomalie durch eine vom Sollverhalten abweichende zeitliche Veränderung mindestens einer der über die Anomalieursachen identifizierten Messgrößen oder durch eine Funktionsbeeinträchtigung des die jeweilige Messgröße messenden Messgeräts verursacht worden ist, indem eine Messgenauigkeit der über die Anomalieursachen identifizierten Messgeräte überprüft wird.

Gemäß einer dritten Ausgestaltung werden die Trainingsdaten in einem Trainingszeitraum erfasst, in dem von einem fehlerfreiem Betrieb der Anlage und der Messgeräte ausgegangen werden kann, und in dem der Prozess mehrfach hintereinander durchgeführt wird.

Die Erfindung und weitere Vorteile werden nun anhand der Figuren der Zeichnung, in denen ein Ausführungsbeispiel dargestellt ist, näher erläutert. Gleiche Elemente sind in den Figuren mit den gleichen Bezugszeichen versehen.
- Fig. 1 zeigt:: eine Anlage zur wiederholten Ausführung eines dynamischen Prozesses;
- Fig. 2 zeigt:: Messwerte von drei verschiedenen Messgrößen;
- Fig. 3 zeigt:: Änderungsgeschwindigkeiten der in Fig. 2 dargestellten Messwerte; und
- Fig. 4 zeigt:: ein Referenzcluster und einen außerhalb des Referenzclusters liegenden Vektor.

Die Erfindung betrifft ein Verfahren, insb. ein computerimplementiertes Verfahren, zur zur Überwachung von auf einer verfahrenstechnischen Anlage während wiederholter Ausführungen eines vorgegebenen dynamischen Prozesses mit einer Gruppe von auf der Anlage eingesetzten Messgeräten MDj fortlaufend gemessenen, sich während der Prozesse zeitlich verändernden Messgrößen Mj.

Als verfahrenstechnische Anlage eignen sich aus dem Stand der Technik bekannte Anlagen zur wiederholten Ausführung eines vorgegebenen dynamischen Prozesses. Beispiele hierfür sind Industrieanlagen, wie z.B. Herstellungs-, Verarbeitungs- und Aufbereitungsanlagen, wie sie heute bereits in einer Vielzahl unterschiedlicher Industriezweige, wie z.B. der chemischen Industrie, der Lebensmittelindustrie, sowie in der Wasser- und/oder Abwasseraufbereitung, eingesetzt werden. Als mittels der Anlage wiederholt ausführbarer dynamischer Prozess eignet sich insb. ein Prozess, der einen oder mehrere zeitlich nacheinander auszuführende Prozessschritte umfasst. Beispiele sind mittels der Anlage ausführbare Herstellungs- , Verarbeitungs- und/oder und Aufbereitungsprozesse.

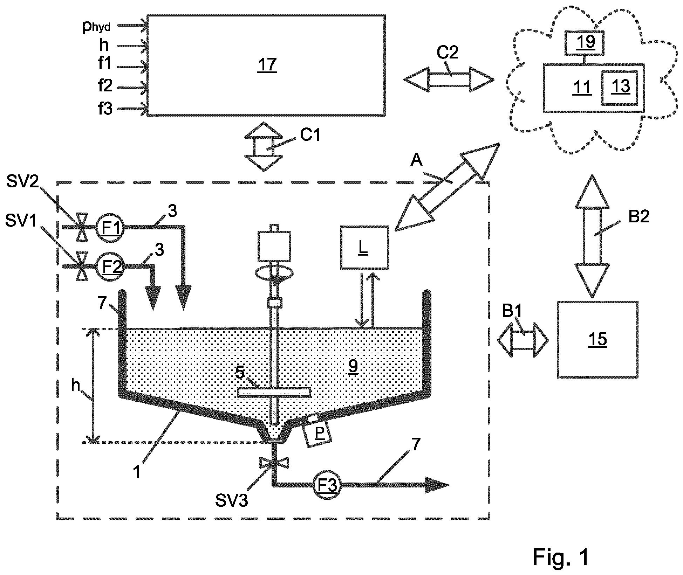

Fig. 1 zeigt als ein Beispiel eine verfahrenstechnische Anlage zur Herstellung eines Prozessprodukts. Die Anlage umfasst einen Behälter 1, der über Zuleitungen 3 mit verschiedenen Eingangsmedien befüllbar ist, die im Behälter 1 mittels eines Rührwerks 5 zu einem Prozessprodukt verarbeitet werden, das dann über eine Entnahmeleitung 7 aus dem Behälter 1 entnommen wird. Dieser Prozess wird auf der Anlage fortlaufend wiederholt, wobei bei jeder Durchführung des Prozesses jeweils eine vorgegebene Menge des Prozessprodukts produziert und aus dem Behälter 1 entnommen wird.

Als auf der Anlage eingesetzte Messgeräte MDj eignen sich aus dem Stand der Technik bekannte Messgeräte zur Messung mindestens einer Messgröße. Hierzu zählen z.B. Sensoren, Sensoren umfassende Messaufnehmer, sowie mit mindestens einem Sensor und/oder einem Messaufnehmer ausgestattete Messgeräte, die dazu ausgestaltet sind mindestens eine Messgröße Mj messtechnisch zu erfassen. Beispiele hierfür sind Druckmessgeräte, Füllstandsmessgeräte, Dichtemessgeräte, Temperaturmessgeräte, Durchflussmessgeräte, pH-Wert Messgeräte etc., wie sie z.B. von der Endress + Hauser Gruppe vertrieben werden. Die in Fig. 1 als ein mögliches Beispiel dargestellte Gruppe von Messgeräten MDj umfasst:
- ein Füllstandsmessgerät L zur Messung eines Füllstandes h eines im Behälter 1 befindlichen Füllguts 9,
- mindestens ein jeweils in eine der Zuleitungen 3 oder in die Entnahmeleitung 7 eingesetztes Durchflussmessgerät F1, F2, F3 zur Messungen eines durch die jeweilige Leitung hindurch strömenden Durchflusses f1, f2, f3, und
- einen Druckmessgerät P zur Messung eines von dem im Behälter 1 befindlichen Füllgut 9 ausgeübten hydrostatischen Drucks p_{hyd}.

Selbstverständlich können je nach Art der Anlage und/oder des jeweiligen mittels der Anlage wiederholt auszuführenden Prozesses auch andere Messgeräte MDj zum Einsatz kommen.

Im Betrieb wird mit der Anlage immer wieder der vorgegebene dynamische Prozess ausgeführt. Zugleich werden die Messgrößen Mj fortlaufend mit den Messgeräten MDj gemessen. Dabei werden fortlaufend Messdaten D erfasst, die während des Betriebs der Anlage mittels der Messgeräte MDj gemessene Messwerte mj(ti) der Messgrößen Mj und die zugehörigen Messzeiten ti, zu denen die jeweiligen Messwerte mj(ti) gemessen wurden, umfassen.

Die fortlaufend erfassten Messdaten D umfassen zu Beginn des Verfahrens in einem Trainingszeitraum erfasste Trainingsdaten DT, sowie im Anschluss an den Trainingszeitraum erfasste Überwachungsdaten DU. Dabei liegt der Trainingszeitraum in einem Zeitraum, in dem von einem fehlerfreiem Betrieb der Anlage und der Messgeräte MDj ausgegangen werden kann, und ist derart bemessen, dass der Prozess während des Trainingszeitraums mehrfach hintereinander durchgeführt wird.

Die Erfassung der Messdaten D erfolgt z.B. in dem die Messwerte mj(ti) der Messgrößen Mj und die zugehörigen Messzeiten ti an eine Datenverarbeitungseinrichtung 11 übermittelt und zumindest vorübergehend in einem der Datenverarbeitungseinrichtung 11 zugeordneten Speicher 13 abgespeichert werden.

Je nach Messgerät Mj und Ausgestaltung der Anlage, kann die Übermittlung der Messwerte mj(ti) mindestens eines Messgeräts Mj und der zugehörigen Messzeiten ti jeweils entweder über eine direkte Verbindung A zwischen dem jeweiligen Messgerät Mj und der Datenverarbeitungseinrichtung 11 oder über eine von dem jeweiligen Messgerät Mj über mindestens eine Zwischenstation zur Datenverarbeitungseinrichtung 11 verlaufende Verbindung B1, B2; C1, C2 erfolgen. Eine direkte Verbindung A ist in Fig. 1 am Beispiel des Füllstandsmessgeräts L dargestellt. Als Zwischenstation eignet sich z.B. ein auf der Anlage oder in der Nähe der Anlage angeordnetes Edge Device 15 und/oder eine übergeordnete Einheit 17. Als übergeordnete Einheit 17 eignet sich z.B. eine Einheit, wie z.B. ein Prozessleitsystem oder eine speicherprogrammierbare Steuerung, die den mittels der Anlage auszuführenden Prozess anhand der Messwerte mj(ti) der Messgeräte MDj überwacht, steuert und/oder regelt. Bei der in Fig. 1 dargestellten Anlage kann die übergeordnete Einheit 17 z.B. derart ausgebildet sein, dass sie den Zufluss der Eingangsmedien und/oder die Entnahme des Prozessprodukts in Abhängigkeit von dem gemessenen hydrostatischen Druck p_{hyd}, dem gemessenen Füllstand h und/oder mindestens einem der gemessenen Durchflüsse f1, f2, f3 über eine entsprechende Ansteuerung von in die Zuleitungen 3 und in die Entnahmeleitung 7 eingesetzten steuerbaren Ventile SV1, SV2, SV3 steuert oder regelt.

Zur Übermittlung der Messdaten D eignen sich z.B. leitungsgebundene und/oder drahtlose Verbindungen A, B1, B2, C1, C2 und/oder aus dem Stand der Technik bekannte Kommunikationsprotokolle. Beispiele sind LAN, W-LAN, Feldbus, Profibus, Hart, Bluetooth und Near Field Communication. Optional ist mindestens eines der Messgeräte Mj, das Edge Device 15 und/oder die übergeordnete Einheit 17 über das Internet, z.B. über über ein Kommunikationsnetzwerk, wie z.B. TCP/IP, mit der Datenverarbeitungseinrichtung 11 verbunden.

Als Datenverarbeitungseinrichtung 11 kann z.B. ein einzelner Computer, ein Großrechner oder eine sonstige Datenverarbeitungseinrichtung eingesetzt werden. Alternativ kann die Datenverarbeitungseinrichtung 11 eine in der Cloud angelegte Einrichtung sein. In dem Fall wird eine unter dem Begriff 'Cloud Computing' bekannte Vorgehensweise genutzt. Cloud Computing umschreibt den Ansatz, abstrahierte IT-Infrastrukturen, wie Hardware, Rechenkapazität, Datenspeicher, Netzwerkkapazitäten oder auch Software dynamisch an den Bedarf angepasst über ein Netzwerk - z.B. ein drahtlos oder drahtgebundenes Internet - zur Verfügung zu stellen.

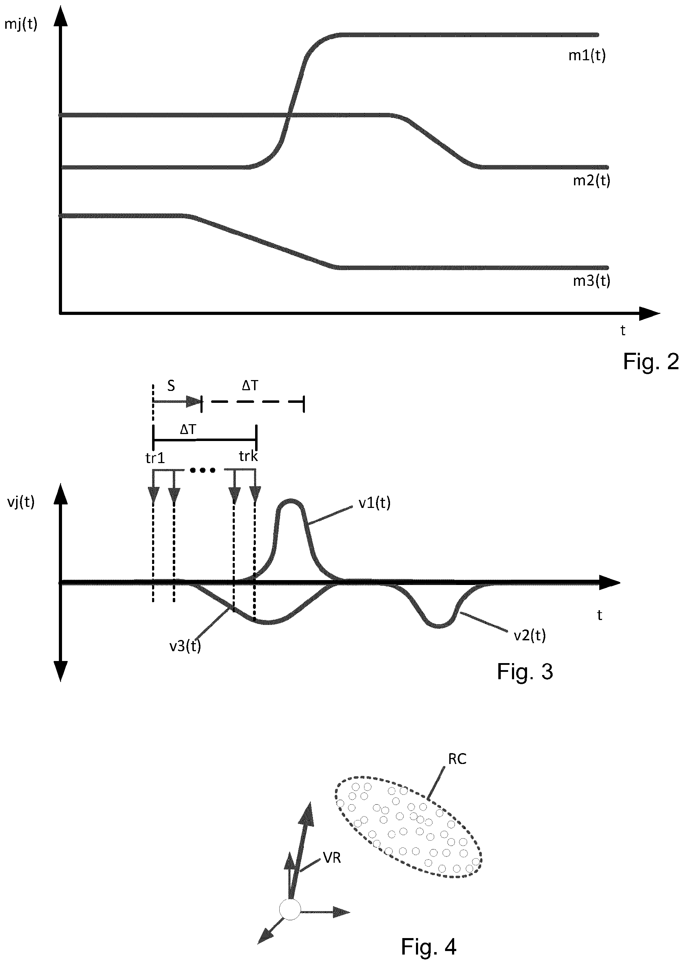

Die fortlaufend erfassten Messdaten D geben einen zeitlichen Verlauf der mit dem Messgeräten MDj gemessenen Messwerte mj(ti) der Messgrößen Mj wieder. Anhand der Messdaten D werden fortlaufend Änderungsgeschwindigkeiten vj(ti) der Messwerte mj(ti) der einzelnen Messgrößen Mj bestimmt. Fig. 2 zeigt als Beispiel einen kurzen Ausschnitt eines zeitlichen Verlaufs von Messwerten m1(t), m2(t), m3(t) von drei verschiedenen sich zeitlich verändernden Messgrößen M1, M2, M3. Fig. 3 zeigt den zeitlichen Verlauf der Änderungsgeschwindigkeiten v1(t), v2(t), v3(t) der in Fig. 2 dargestellten Messwerte m1(t), m2(t), m3(t).

Bei einem deterministischen, fehlerfrei immer wieder gleich ablaufendem Prozess und einer fehlerfreien Messung der Messgrößen Mj beschreibt ein aus den Änderungsgeschwindigkeiten vj(t) gebildeter Geschwindigkeitsvektor v(t) mit v(t):= (v1(t),...,vn(t)) als Funktion der Zeit t eine zu einem Ring geschlossene Trajektorie in einem n-dimensionalen Raum, wobei die Dimension n des Raums der Anzahl der Messgrößen Mj entspricht. Diese Trajektorie wird bei jeder Durchführung des Prozesses erneut durchlaufen und gibt die über den Prozess, die Reaktionsgeschwindigkeit der einzelnen Messgrößen Mj auf die Prozessdynamik und die messgerätabhängige Reaktionsgeschwindigkeit der Messwerte mj(ti) auf Veränderungen der Messgröße Mj vorgegebene zeitliche Kopplung der Änderungsgeschwindigkeiten vj(t) der Messwerte mj(ti) der Messgrößen Mj im Verbund wieder.

Basierend auf den Änderungsgeschwindigkeiten vj(ti) werden fortlaufend Vektoren VR bestimmt, deren Vektorkomponenten jeweils die für eine Reihe von k aufeinander folgende Zeitpunkte [tr1, , ..., trk] bestimmten Änderungsgeschwindigkeiten vj(ti) der Messwerte mj(ti) der einzelnen Messgrößen Mj umfassen. Jeder dieser Vektoren VR umfasst folglich die Vektorkomponenten: VR:= (m₁(tᵣ₁), ..., m₁(tᵣₖ), ...., mₙ(tᵣ₁), ... , mₙ(tᵣₖ)) wobei n gleich der Anzahl der Messgrößen Mj und k gleich der Anzahl der aufeinander folgenden Zeitpunkte [tr1, , ..., trk] der Reihe ist. Unabhängig von der Anzahl der Messgrößen Mj und der Anzahl k der Zeitpunkte [tr1, , ..., trk] decken die Zeitpunkte [tr1, , ..., trk] jeder Reihe jeweils ein Zeitfenster vorgegebener Dauer ΔT ab. Ein solches Zeitfenster ist in Fig. 3 als Beispiel dargestellt. Die Zeitfenster sind als gleitende Fenster ausgebildet. D.h. die Zeitfenster aufeinander folgender Vektoren (VR) sind gegeneinander jeweils um eine in Fig. 3 durch einen parallel zur Zeitachse verlaufenden Verschiebungspfeil S angezeigte, vorgegebene Zeitdifferenz verschoben. Durch jeden dieser Vektoren VR wird folglich der zeitliche Verlauf der Änderungsgeschwindigkeiten vj(ti) der Messwerte mj(ti) der Messgrößen Mj im Verbund in einem dem jeweiligen Zeitfenster entsprechenden Segment der durch den Geschwindigkeitsvektor v(t) als Funktion der Zeit beschriebenen Trajektorie erfasst.

In einem ersten Schritt, werden die anhand der Trainingsdaten TD bestimmten Vektoren VR in Form eines Referenzcluster RC erfasst und abgespeichert. Im Anschluss daran wird ein Überwachungsverfahren ausgeführt, bei dem die fortlaufend anhand der Überwachungsdaten DU bestimmten Vektoren VR mit dem zuvor anhand der Trainingsdaten DT bestimmten Referenzcluster RC verglichen werden. Anhand dieses Vergleichs wird überprüft, ob mindestens einer dieser Vektoren VR außerhalb des Referenzclusters RC liegt. Wenn das der Fall ist, wird eine Anomalie festgestellt und eine Information über die festgestellte Anomalie zur Verfügung gestellt.

Fig. 4 zeigt hierzu eine Prinzipskizze, in der die anhand der Trainingsdaten DT bestimmten, das Referenzcluster RC bildenden Vektoren VR als Punkte dargestellt sind, und in der ein anhand der Überwachungsdaten DU bestimmter, außerhalb des Referenzclusters RC liegenden Vektor VR als vom Koordinatenursprung des n*k -dimensionalen Raums ausgehender Pfeil dargestellt ist.

Die Bestimmung der Vektoren VR, die Bestimmung des Referenzclusters RC, sowie die im Anschluss an die Bestimmung des Referenzclusters RC anhand der Vektoren VR ausgeführte Überwachung wird vorzugsweise mittels der Datenverarbeitungseinrichtung 11 ausgeführt. In dem Fall ist die Datenverarbeitungseinrichtung 11 vorzugsweise dazu ausgebildet, die Information über die festgestellte Anomalien über eine an die Datenverabeitungseinrichtung 11 angeschlossene Schnittstelle 19 auszugeben und/oder in über die Schnittstelle 19 auslesbarer und/oder abrufbarer Form zur weiteren Nutzung zur Verfügung zu stellen. Wird die Information ausgegeben, so kann dies z.B. in Form eines Alarms, eines Ausgangssignal oder in Form einer e-mail oder einer Textnachricht an einen vorgegebenen Empfänger, wie z.B. eine vorgegebene E-Mail Adresse, ein Smartphone oder ein Tablet, erfolgen.

Das Überwachungsverfahren basiert darauf, dass die Messwerte mj(ti) aller Messgrößen Mj über die Prozessdurchführung zeitlich gekoppelt sind. Das führt dazu, dass jedes dynamische Prozessereignis bei fehlerfreiem Betrieb der Anlage bewirkt, dass sich die von dem Prozessereignis betroffenen Messgrößen Mj mit einer vom Prozess abhängigen Reaktionszeit und einer vom Prozess abhängigen Reaktionsamplitude zeitlich verändern. Bei fehlerfreiem Betrieb der Messgeräte MDj verändern sich dementsprechend auch die Messwerte mj(ti) der Messgrößen Mj jeweils mit einer von der Reaktionszeit und der Reaktionsamplitude der Messgröße Mj und von dem Messeigenschaften des Messgeräts Mj abhängigen Reaktionszeit und Reaktionsamplitude. Entsprechend werden über den Vergleich mit dem Referenzclusters RC Anomalien erkannt, die dazu führen, dass sich die Messwerte mj(ti) mindestens einer der Messgrößen Mj in Relation zu den Messwerten mj(ti) der anderen Messgrößen Mj mit einer von dem Referenzcluster RC abweichenden Reaktionszeit und/oder Reaktionsamplitude zeitlich verändern. Das bietet den Vorteil, dass mit nur einem einheitlichen anhand des Referenzclusters RC ausgeführten Überwachungsverfahren sowohl prozess- oder anlagen-bedingte Anomalien erkannt werden, die dazu führen, dass sich mindestens eine der anhand der Messwerte mj(ti) überwachten Messgrößen Mj in Relation zu den Messwerten mj(ti) der anderen Messgrößen Mj zeitlich in einer vom Referenzcluster RC abweichenden Weise verändert, als auch Anomalien erkannt werden, bei denen sich Messwerte mj(ti) mindestens eines der Messgeräte MDj aufgrund einer Funktionsbeeinträchtigung des jeweiligen Messgeräts MDj in Relation zu den Messwerten mj(ti) der anderen Messgeräte MDj zeitlich in einer vom Referenzcluster RC abweichenden Weise verändern. Ein Beispiel für eine prozessbedingte Anomalie ist eine z.B. durch eine fehlerhafte Steuerung oder Regelung des Prozesses bedingte fehlerhafte Prozessdurchführung. Ein Beispiel für eine anlagenbedingte Anomalie ist ein Loch im Behälter 1, das zu einem zeitlich verzögerten und/oder betragsmäßig verringerten Anstieg des Füllstands h führt. Beispiele für mittels des Verfahrens als Anomalie erkennbare Funktionsbeeinträchtigungen der Messgeräte MDj sind Funktionsbeeinträchtigungen, wie z.B. ein Spannefehler, die sich auf die Amplitude der Änderungsgeschwindigkeiten vj(ti) der Messwerte mj(ti) auswirken, sowie Funktionsbeeinträchtigungen, die sich auf die Reaktionszeit der Messwerte mj(ti) des Messgerät MDj auf Messgrößenänderungen auswirken.

Das Verfahren weist die eingangs genannten Vorteile auf. Optional können einzelne Verfahrensschritte unterschiedliche einzeln oder in Kombination miteinander einsetzbare Ausgestaltungen aufweisen. Beispiele hierzu sind nachfolgend beschrieben.

So kann die Dauer ΔT der Zeitfenster z.B. auf unterschiedliche Weise bestimmt werden. Eine Option besteht darin, die Dauer ΔT der Zeitfenster anhand einer Prozessdauer des wiederkehrend auf der Anlage ausgeführten Prozesses derart zu bestimmen, dass die Dauer ΔT kleiner gleich der Prozessdauer des ausgeführten Prozesses ist. Bei sehr kurzer Prozessdauer, wie z.B. einer Prozessdauer von einer oder wenigen Minuten, kann die Dauer ΔT der Zeitfenster z.B. im Wesentlichen gleich der Prozessdauer sein. Bei längerer Prozessdauer kann die Dauer ΔT der Zeitfenster z.B. derart bestimmt werden, dass sie gleich einem vorgegebenen prozentualen Anteil der Prozessdauer, wie z.B. einem Anteil von 5% bis 10% der Prozessdauer, entspricht.

Alternativ oder zusätzlich hierzu wird die Dauer ΔT der Zeitfenster z.B. derart bemessen, dass sie größer gleich der Dauer mindestens eines während jeder Durchführung des Prozesses auftretenden dynamischen Prozessereignisses ist, durch das sich mindestens zwei der Messgrößen Mj zeitlich verändern. Beispiele für dynamische Prozessereignisse sind der mittels der in Fig. 1 dargestellte Anlage ausgeführte Befüllvorgänge und Entleerungsvorgänge, bei denen sich jeweils der Durchfluss f1, f2, f3 durch die zugehörige Zuleitung 3 oder die Entnahmeleitung 7, der Füllstand h im Behälter 1 und der hydrostatische Druck p_{hyd} im Behälter 1 ändern.

Alternativ oder zusätzlich hierzu kann die Dauer ΔT der Zeitfenster derart vorgegeben werden, dass sie größer gleich mindestens einer jeweils einer der Messgrößen Mj zugeordneten Reaktionszeit ist, mit der sich der Messwert mj(ti) der jeweiligen Messgröße Mj in Reaktion auf ein dynamisches Prozessereignis verändert. Diese Reaktionszeiten können z.B. anhand der Trainingsdaten DT abgeschätzt werden. Das kann z.B. derart erfolgen, dass anhand der Änderungsgeschwindigkeiten vj(ti) der Messwerte mj(ti) einer der Messgrößen Mj ein Startzeitpunkt ta bestimmt wird, an dem die Änderungsgeschwindigkeiten vj(ti) der Messwerte mj(ti) dieser Messgröße Mj einen vorgegebenen Grenzwert übersteigen und anhand der Messwerte mj(ti) der anderen Messgrößen Mj für jede der anderen Messgrößen Mj jeweils ein messgrößen-spezifischer Endzeitpunkt tej bestimmt wird, an dem die Änderungsgeschwindigkeiten vj(ti) der Messwerte mj(ti) der jeweiligen anderen Messgröße Mj nach dem Startzeitpunkt ta erstmals einen vorgegebenen Grenzwert übersteigen. Anschließend werden für jede Messgröße Mj jeweils die Differenz Δtj := tej -ta zwischen dem messgrößen-spezifische Endzeitpunkt tej und dem Startzeitpunkt ta bestimmt. In dem Fall bildet jede der Differenzen Δtj jeweils einen Schätzwert für eine Reaktionszeit, anhand derer die Dauer ΔT der Zeitfenster derart bestimmt wird, dass sie größer gleich mindestens eines dieser Schätzwerte ist.

Alternativ oder zusätzlich hierzu kann die Dauer ΔT der Zeitfenster derart vorgegeben werden, dass sie größer gleich mindestens einer jeweils für eine der Messgrößen Mj bestimmten Zeitskala ist, auf der sich die Messwerte mj(ti) der jeweiligen Messgröße Mj zeitlich verändern. Diese Zeitskala kann für jede Messgröße Mj anhand der Trainingsdaten TD ermittelt werden. Dabei werden z.B. anhand der Änderungsgeschwindigkeiten vj(ti) der Messwerte mj(ti) der jeweiligen Messgröße Mj Zeiträume ermittelt, in denen sich die Messwerte mj(ti) zeitlich verändern und ein Mittelwert der in diesen Zeiträumen auftretenden Änderungsgeschwindigkeiten vj(ti) bestimmt. Anhand dieses Mittelwerts wird die Zeitskala bestimmt. Optional kann dies z.B. derart erfolgen, dass die Zeitskala gleich einem Zeitinterval gesetzt wird, in dem sich die Messwerte mj(ti) bei einer dem Mittelwert entsprechenden Änderungsgeschwindigkeit vj(ti) um einen vorgegebenen Anteil, wie z.B. einem Anteil von größer gleich 40 % oder von größer gleich 60%, des Messbereichs des jeweiligen Messgeräts MDj verändern.

Unabhängig davon, ob die Dauer ΔT der Zeitfenster anhand der Prozessdauer, der Dauer mindestens eines während jeder Durchführung des Prozesses auftretenden dynamischen Prozessereignisses, mindestens einer jeweils einer der Messgrößen Mj zugeordneten Reaktionszeit, und/oder anhand mindestens einer jeweils einer der Messgrößen Mj zugeordneten Zeitskala bestimmt werden, können auch die Zeitabstände zwischen den innerhalb der Zeitfenster aufeinander folgenden Zeitpunkten tr1,..,trk auf unterschiedliche Weise bestimmt oder vorgegeben werden. Optional kann z.B. eine konstante Diskretisierungszeit angesetzt werden. In dem Fall sind die Zeitabstände zwischen den unmittelbar aufeinander folgenden Zeitpunkten tr1,..,trk jeweils gleich der vorgegebenen konstanten Diskretisierungszeit.

Die Diskretisierungszeit ist vorzugsweise derart bemessen, dass sie klein genug ist, um die Prozessdynamik des Prozesses noch auflösen zu können. Hierzu kann die Diskretisierungszeit z.B. gleich einem anhand des Prozesses ermittelten Schätzwert gesetzt werden. Alternativ oder zusätzlich hierzu kann die Diskretisierungszeit anhand mindestens einer der auf die zuvor beschrieben Weise anhand der Trainingsdaten DT ermittelbaren Zeitskalen bestimmt werden. Dabei wird die Diskretisierungszeit z.B. derart bestimmt, dass sie kleiner gleich dem Zeitraum ist, in dem sich die Messwert mj(ti) der jeweiligen Messgröße Mj bei einer dem Mittelwert entsprechenden Änderungsgeschwindigkeit vj(ti) um einen vorgegebenen Prozentsatz der Messwertspanne, wie z.B. einem Prozentsatz von kleiner gleich 10% oder kleiner gleich 5 % des Messbereichs des jeweiligen Messgeräts MDj verändern. Dabei ist dieser Prozentsatz natürlich deutlich geringer anzusetzen, als der zur Bestimmung der Dauer ΔT der Zeitfenster herangezogene Anteil des Messbereichs.

Die in Fig. 3 durch den Verschiebungspfeil S dargestellte Zeitdifferenz, um die die Zeitfenster aufeinander folgender Vektoren VR zeitlich gegeneinander verschoben sind, ist z.B. derart bemessen, dass sie größer als die Diskretisierungszeit und/oder kleiner gleich der Dauer ΔT der Zeitfenster ist.

Wird durch das Überwachungsverfahren eine Anomalie festgestellt, wird vorzugsweise deren Ursache ermittelt und durch eine entsprechende Gegenmaßnahme behoben. Bezüglich der Ermittlung der Ursache wird optional z.B. derart verfahren, dass für mindestens einen anhand des Überwachungsverfahrens als außerhalb des Referenzclusters RC liegender Vektor VR identifizierten Vektor VR anhand eines Abstands des jeweiligen Vektors VR vom Referenzcluster RC mindestens eine Anomalieursache ermittelt wird. Hierzu wird für jede Messgröße Mj jeweils ein anteiliger Beitrag der Änderungsgeschwindigkeiten vj(ti) der Messwerte mj(ti) der jeweiligen Messgröße Mj zum Abstand dieses Vektors VR vom Referenzcluster RC bestimmt. Anschließend werden die Messwerte mj(ti) mindestens einer der Messgrößen Mj jeweils als Anomalieursache identfiziert. Als Anomalieursache werden insoweit z.B. die Messwerte mj(ti) derjenigen Messgröße Mj bestimmt, deren anteiliger Beitrag den größten Wert aufweist. Alternativ oder zusätzlich hier werden als Anamalieursache z.B. die Messwerte mj(ti) derjenigen Messgrößen Mj bestimmt, deren anteiliger Beitrag einen vorgegebenen Grenzwert überschreitet.

Auch die Ermittlung der Anomalieursachen wird z.B. mittels der Datenverarbeitungseinrichtung 11 ausgeführt und es wird eine Information über die ermittelteten Anomalieursachen zur Verfügung gestellt. Letztere wird z.B. über die an die Datenverabeitungseinrichtung 11 angeschlossene Schnittstelle 19 ausgegeben und/oder von der Datenverabeitungseinrichtung 11 in über die Schnittstelle 19 auslesbarer und/oder abrufbarer Form zur Verfügung zu gestellt.

Die Anomalieursachen erleichtern es dem Betreiber der Anlage die der Anomalie zugrunde liegende Ursache zu bestimmen und dementsprechende Gegenmaßnahmen zu ergreifen. Optional wird hierzu z.B. überprüft, ob die durch das Überwachungsverfahren detektierte Anomalie durch eine vom Sollverhalten abweichende zeitliche Veränderung mindestens einer der über Anomalieursachen identifizierten Messgrößen Mj oder durch eine Funktionsbeeinträchtigung des die jeweilige Messgröße Mj messenden Messgeräts MDj verursacht worden ist. Hierzu wird z.B. derart Verfahren werden, dass zunächst die Messgenauigkeit der über die Anomalieursachen identifizierten Messgeräte MDj überprüft wird. Das kann z.B. anhand von im laufenden Betrieb der Anlage oder im Rahmen eines Kalibrationsverfahrens ausgeführten Referenzmessungen erfolgen. Wird hierbei eine Funktionsbeeinträchtigung eines der Messgeräte MDj festgestellt, wird das jeweilige Messgerät MDj rekalibriert oder ausgetauscht. Liegt keine Funktionsbeeinträchtigung der Messgeräte MDj vor, so wird die Ursache vorzugsweise ermittelt, indem zunächst Bereiche der Anlage und der Anlagensteuerung und/oder-regelung untersucht werden, die Einfluss auf die über die Anomalieursachen identifizierten Messgrößen Mj haben.

**Bezugszeichenliste**

| | | | |
|---|---|---|---|
| 1 | Behälter | 13 | Speicher |
| 3 | Zuleitung | 15 | Edge Device |
| 5 | Rührwerk | 17 | Übergeordnete Einheit |
| 7 | Entnahmeleitung | 19 | Schnittstelle |
| 9 | Füllgut | | |
| 11 | Datenverarbeitungseinrichtung | | |

## Patentansprüche

1. Verfahren zur Überwachung von auf einer verfahrenstechnischen Anlage während wiederholter Ausführungen eines vorgegebenen dynamischen Prozesses mit einer Gruppe von auf der Anlage eingesetzten Messgeräten (MDj) fortlaufend gemessenen, sich während der Prozesse zeitlich verändernden Messgrößen (Mj), bei dem:
während der wiederholten Ausführungen des dynamischen Prozesses fortlaufend Messdaten (D) erfasst werden, die mittels der Messgeräte (MDj) gemessene Messwerte (mj(ti)) der Messgrößen (Mj) und die zugehörigen Messzeiten (ti), zu denen die Messwerte (mj(ti)) gemessen wurden, umfassen,
wobei die Messdaten (D) in einem Trainingszeitraum gemessene Trainingsdaten (DT) und im Anschluss an den Trainingszeitraum gemessene Überwachungsdaten (DU) umfassen,
anhand der Messdaten (D) fortlaufend Vektoren (VR) bestimmt werden, deren Vektorkomponenten jeweils für eine Reihe von k aufeinander folgenden Zeitpunkten ([tr1, , ..., trk]) anhand der Messdaten (D) bestimmte Änderungsgeschwindigkeiten (η(ti)) der Messwerte (mj(ti)) der einzelnen Messgrößen (Mj) umfassen, wobei die Zeitpunkte ([tr1, , ..., trk]) jeder Reihe jeweils ein Zeitfenster vorgegebener Dauer (ΔT) abdecken und die Zeitfenster aufeinander folgender Vektoren (VR) gegeneinander jeweils um eine vorgegebene Zeitdifferenz verschoben sind,
die anhand der Trainingsdaten (DT) bestimmten Vektoren (VR) in Form eines Referenzclusters (RC) erfasst und abgespeichert werden, und
ein Überwachungsverfahren ausgeführt wird, bei dem:
die anhand der Überwachungsdaten (DU) bestimmten Vektoren (VR) jeweils mit dem Referenzcluster (RC) verglichen werden,
eine Anomalie festgestellt wird, wenn mindestens einer der anhand der Überwachungsdaten (DU) bestimmten Vektoren (VR) außerhalb des Referenzcluster (RC) liegt, und
eine Information über die festgestellte Anomalie zur Verfügung gestellt wird.

2. Verfahren gemäß Anspruch 1, bei dem:
die Erfassung der Messdaten (D) derart erfolgt, dass die Messwerte (mj(ti)) der Messgrößen (Mj) und die zugehörigen Messzeiten (ti) an eine Datenverarbeitungseinrichtung (11) übermittelt werden und zumindest vorübergehend in einem der Datenverarbeitungseinrichtung (11) zugeordneten Speicher (13) abgespeichert werden, und
die Datenverarbeitungseinrichtung (11) dazu ausgebildet ist, anhand der Messdaten (D) die Bestimmung der Vektoren (VR), die Bestimmung des Referenzclusters (RC) und das Überwachungsverfahren auszuführen, und dazu ausgebildet ist, die Information über die festgestellte Anomalie über eine an die Datenverarbeitungseinrichtung (11) angeschlossene Schnittstelle (19) auszugeben und/oder in über die Schnittstelle (19) auslesbarer und/oder abrufbarer Form zur Verfügung zu stellen.

3. Verfahren gemäß Anspruch 1 bis 2, bei dem die vorgegebene Dauer (ΔT) der Zeitfenster:
kleiner gleich einer Prozessdauer des Prozesses ist,
größer gleich einer Dauer mindestens eines während jeder Durchführung des Prozesses auftretenden dynamischen Prozessereignisses ist, durch das sich mindestens zwei der Messgrößen (Mj) zeitlich verändern,
größer gleich mindestens einer jeweils einer der Messgrößen (Mj) zugeordneten Reaktionszeit ist, mit der sich die Messwerte (mj(ti) der jeweiligen Messgröße (Mj) in Reaktion auf ein dynamisches Prozessereignis verändern, und/oder
größer gleich mindestens einer jeweils einer der Messgrößen (Mj) zugeordneten Zeitskala ist, auf der sich die Messwerte (mj(ti)) der jeweiligen Messgröße (Mj) zeitlich verändern.

4. Verfahren gemäß Anspruch 1 bis 3, bei dem die vorgegebene Dauer (ΔT) der Zeitfenster anhand der Trainingsdaten (TD) bestimmt wird, indem:
anhand der Änderungsgeschwindigkeiten (η(ti)) der Messwerte (mj(ti)) einer der Messgrößen (Mj) ein Startzeitpunkt (ta) bestimmt wird, an dem die Änderungsgeschwindigkeiten (η(ti)) der Messwerte (mj(ti)) dieser Messgröße (Mj) einen vorgegebenen Grenzwert übersteigen,
anhand der Messwerte (mj(ti)) der anderen Messgrößen (Mj) für jede der anderen Messgrößen (Mj) jeweils ein messgrößen-spezifischer Endzeitpunkt (tej) bestimmt wird, an dem die Änderungsgeschwindigkeiten (η(ti)) der Messwerte (mj(ti)) der jeweiligen anderen Messgröße (Mj) nach dem Startzeitpunkt (ta) erstmals einen vorgegebenen Grenzwert übersteigen,
für jede Messgröße (Mj) jeweils eine Differenz (Δtj := tej -ta) zwischen dem messgrößen-spezifische Endzeitpunkt (tej) und dem Startzeitpunkt (ta) bestimmt wird, und
die Dauer (ΔT) der Zeitfenster derart bestimmt wird, dass sie größer gleich mindestens einer dieser Differenzen (Δtj := tej -ta) ist.

5. Verfahren gemäß Anspruch 1 bis 4, bei dem die vorgegebene Dauer (ΔT) der Zeitfenster anhand der Trainingsdaten (DT) bestimmt wird, indem:
für mindestens eine der Messgrößen (Mj) jeweils:
anhand der Änderungsgeschwindigkeiten (η(ti)) der Messwerte (mj(ti)) der jeweiligen Messgröße (Mj) Zeiträume ermittelt werden, in denen sich die Messwerte (mj(ti)) der jeweiligen Messgröße (Mj) zeitlich verändern und ein Mittelwert der in diesen Zeiträumen auftretenden Änderungsgeschwindigkeiten (η(ti)) bestimmt wird, und
eine Zeitskala bestimmt wird, die einem Zeitraum entspricht, in dem sich die Messwerte (mj(ti)) dieser Messgröße (Mj) bei einer dem Mittelwert entsprechenden Änderungsgeschwindigkeit (η(ti)) um einen vorgegebenen Anteil, um einem Anteil von größer gleich 40 % oder um einen Anteil von größer gleich 60% eines Messbereichs des die jeweilige Messgröße (Mj) messenden Messgeräts (MDj) verändert, und
die Dauer (ΔT) der Zeitfenster derart bestimmt wird, dass sie größer gleich mindestens einer dieser Zeitskalen ist.

6. Verfahren gemäß Anspruch 1 bis 5, bei dem die Zeitabstände zwischen den innerhalb der Zeitfenster aufeinander folgenden Zeitpunkten (tr1,..,trk) jeweils gleich einer vorgegebenen konstanten Diskretisierungszeit sind.

7. Verfahren gemäß Anspruch 6, bei dem die Diskretisierungszeit derart bemessen ist, dass sie klein genug ist um eine Prozessdynamik des Prozesses auflösen zu können.

8. Verfahren gemäß Anspruch 6 bis 7, bei dem die Diskretisierungszeit anhand der Trainingsdaten (TD) bestimmt wird, indem:
für mindestens eine der Messgrößen (Mj) jeweils:
anhand der Änderungsgeschwindigkeiten (η(ti)) der Messwerte (mj(ti)) der jeweiligen Messgröße (Mj) Zeiträume ermittelt werden, in denen sich die Messwerte (mj(ti)) zeitlich verändern und ein Mittelwert der in diesen Zeiträumen auftretenden Änderungsgeschwindigkeiten (η(ti)) bestimmt wird, und
eine Zeitskala bestimmt wird, die einem Zeitraum entspricht, in dem sich die Messwerte (mj(ti)) dieser Messgröße (Mj) bei einer dem Mittelwert entsprechenden Änderungsgeschwindigkeit (η(ti)) um einen vorgegebenen Prozentsatz, um einem Prozentsatz von kleiner gleich 10 % oder um einen Prozentsatz von kleiner gleich 5 % eines Messbereichs des die jeweilige Messgröße (Mj) messenden Messgeräts (MDj) verändert, und
die Diskretisierungszeit derart bestimmt wird, dass sie kleiner gleich mindestens einer dieser Zeitskalen ist.

9. Verfahren gemäß Anspruch 6 bis 8, bei dem die Zeitdifferenz, um die die Zeitfenster aufeinander folgender Vektoren (VR) zeitlich gegeneinander verschoben sind, größer als die Diskretisierungszeit ist und/oder kleiner gleich der Dauer (ΔT) der Zeitfenster ist.

10. Verfahren gemäß Anspruch 1 bis 9, bei dem eine Ursache der durch das Überwachungsverfahren festgestellten Anomalie ermittelt und/oder durch eine entsprechende Gegenmaßnahme behoben wird.

11. Verfahren gemäß Anspruch 10, bei dem für mindestens einen anhand des Überwachungsverfahrens als außerhalb des Referenzclusters (RC) liegender Vektor (VR) identifizierten Vektor (VR) anhand eines Abstands dieses Vektors (VR) vom Referenzcluster (RC) mindestens eine Anomalieursache ermittelt wird, indem:
für jede Messgröße (Mj) jeweils ein anteiliger Beitrag der Änderungsgeschwindigkeiten (η(ti)) der Messwerte (mj(ti)) der jeweiligen Messgröße (Mj) zum Abstand des Vektors (VR) vom Referenzcluster (RC) bestimmt wird, und
als die mindestens eine Anomalieursache die Messwerte (mj(ti)) derjenigen Messgröße(n) (Mj) bestimmt werden deren anteiliger Beitrag den größten Wert aufweist und/oder einen vorgegebenen Grenzwert überschreitet, und
eine Information über die mindestens eine Anomalieursache zur Verfügung gestellt wird.

12. Verfahren gemäß Anspruch 11, bei dem anhand mindestens einer der zuvor bestimmten mindestens einen Anomalieursache die Ursache der mittels des Überwachungsverfahrens festgestellten Anomalie ermittelt wird, indem überprüft wird, ob die durch das Überwachungsverfahren detektierte Anomalie durch eine vom Sollverhalten abweichende zeitliche Veränderung mindestens einer der über die Anomalieursachen identifizierten Messgrößen (Mj) oder durch eine Funktionsbeeinträchtigung des die jeweilige Messgröße (Mj) messenden Messgeräts (MDj) verursacht worden ist, indem eine Messgenauigkeit der über die Anomalieursachen identifizierten Messgeräte (MDj) überprüft wird.

13. Verfahren gemäß Anspruch 1 bis 12, bei dem die Trainingsdaten (DT) in einem Trainingszeitraum erfasst werden, in dem von einem fehlerfreiem Betrieb der Anlage und der Messgeräte (MDj) ausgegangen werden kann, und in dem der Prozess mehrfach hintereinander durchgeführt wird.

## Claims

1. Procedure for monitoring measured variables (Mj) measured continuously on an process engineering system during the repeated execution of a predefined dynamic process with a group of measuring devices (MDj) used in the system, wherein said variables vary over time during the process, wherein:
during the repeated execution of the dynamic process, measured data (D) are continuously captured that comprise measured values (mj(ti)) of the measured variables (Mj) measured using the measuring devices (MDj) and the associated measuring times (ti) when the measured values (mj(ti)) were measured,
wherein the measured data (D) comprise training data (DT) measured during a training period and monitoring data (DU) measured after the training period,
wherein, on the basis of the measured data (D), vectors (VR) are continuously measured whose vector components comprise, in each case, change speeds (vj(ti)) of the measured values (mj(ti)) of the individual measured variables (Mj) determined for a series of k consecutive times ([tr1, ..., trk]) on the basis of the measured data (D), wherein the times ([tr1, ..., trk]) of each series cover a time window of a predefined duration (ΔT) and the time windows of consecutive vectors (VR) are shifted in relation to one another by a predefined time difference,
wherein the vectors (VR) determined using the training data (DT) are captured and saved in the form of a reference cluster (RC), and
a monitoring procedure is performed during which:
the vectors (VR) determined using the monitoring data (DU) are compared, in each case, with the reference cluster (RC),
an anomaly is determined when at least one of the vectors (VR) determined using the monitoring data (DU) is outside the reference cluster (RC), and
information is provided about the anomaly that is determined.

2. Procedure as claimed in Claim 1, wherein:
the measured data (D) are captured in such a way that the measured values (mj(ti)) of the measured variables (Mj) and the corresponding measuring times (ti) are transmitted to a data processing unit (11) and are saved at least temporarily in a memory (13) associated with the data processing unit (11), and
the data processing unit (11) is designed to determine the vectors (VR), determine the reference cluster (RC) and perform the monitoring procedure using the measured data (D), and is designed to output information about the anomaly that is determined via an interface (19) connected to the data processing unit (11) and/or to make the information available in a format that can be read or retrieved via the interface (19).

3. Procedure as claimed in Claim 1 to 2, wherein the predefined duration (ΔT) of the time windows:
is less than or equal to a process duration of the process,
is greater than or equal to a duration of at least a dynamic process event occurring during each execution of the process, causing at least two of the measured variables (Mj) to vary over time,
is greater than or equal to at least a reaction time assigned to one of the measured variables (Mj), with which the measured values (mj(ti)) of the measured variable (Mj) change in response to a dynamic process event, and/or
is greater than or equal to at least a time scale - associated, in each case, with one of the measured variables (Mj) - on which the measured values (mj(ti)) of the respective measured variable (Mj) change over time.

4. Procedure as claimed in Claim 1 to 3, wherein the predefined duration (ΔT) of the time windows is determined using the training data (TO), such that:
using the change speeds (vj(ti)) of the measured values (mj(ti)) of one of the measured variables (Mj), a starting time (ta) is determined at which the change speeds (vj(ti)) of the measured values (mj(ti)) of this measured variable (Mj) exceed a predefined limit value,
using the measured values (mj(ti)) of the other measured variables (Mj), an end time (tej), specific to the measured variable, is determined for each of the other measured variables (Mj), wherein at said end time the change speeds (vj(ti)) of the measured values (mj(ti)) of the other respective measured variable (Mj) exceed a predefined limit value for the first time after the starting time (ta),
a difference (Δtj:= tej -ta) between the end time (tej) specific to the measured variable and the starting time (ta) is determined for each measured variable (Mj), and
the duration (ΔT) of the time windows is determined in such a way that it is greater or equal to at least one of these differences (Δtj:= tej -ta).

5. Procedure as claimed in Claim 1 to 4, wherein the predefined duration (ΔT) of the time windows is determined using the training data (DT) such that:
the following is performed, in each case, for at least one of the measured variables (Mj):
using the change speeds (vj(ti)) of the measured values (mj(ti)) of the respective measured variable (Mj), time periods in which the measured values (mj(ti)) of the respective measured variables (Mj) vary over time are determined and an average value of the change speeds (vj(ti)) occurring in these periods is determined, and
a time scale is determined that corresponds to a period in which the measured values (mj(ti)) of this measured variable (Mj) vary - at a change speed (vj(ti)) corresponding to the average value - by a predefined percentage, by a percentage greater than or equal to 40 % or by a percentage greater than or equal to 60 % of a measuring range of the measuring device (MDj) measuring the respective measured variable (Mj), and
the duration (ΔT) of the time windows is determined in such a way that it is greater than or equal to at least one of these time scales.

6. Procedure as claimed in Claim 1 to 5, wherein the time intervals between the times occurring consecutively (tr1, ..., trk) within the time windows are each equal to a predefined constant discretization time.

7. Procedure as claimed in Claim 6, wherein the discretization time is such that it is small enough to be able to trigger a process dynamic of the process.

8. Procedure as claimed in Claim 6 to 7, wherein the discretization time is determined using the training data (TO), such that:
the following is performed, in each case, for at least one of the measured variables (Mj):
using the change speeds (vj(ti)) of the measured values (mj(ti)) of the measured variable (Mj), periods in which the measured values (mj(ti)) vary over time are determined and an average value of the change speeds (vj(ti)) occurring during these time periods is determined, and
a time scale is determined which corresponds to a period in which the measured values (mj(ti)) of said measured variable (Mj) vary - at a change speed (vj(ti)) corresponding to the average value - by a predefined percentage, by a percentage less than or equal to 10 % or by a percentage less than or equal to 5 % of a measuring range of the measuring device (MDj) measuring the respective measured variable (Mj), and
the discretization time is determined in such a way that it is less than or equal to at least one of these time scales.

9. Procedure as claimed in Claim 6 to 8, wherein the time difference by which the time windows of consecutive vectors (VR) are chronologically shifted in relation to one another is greater than the discretization time and/or is less than or equal to the duration (ΔT) of the time windows.

10. Procedure as claimed in Claim 1 to 9, wherein a cause of the anomaly detected by the monitoring procedure is determined and/or corrected by a corresponding counter-measure.

11. Procedure as claimed in Claim 10, wherein at least an anomaly cause is detected for at least a vector (VR), which is identified using the monitoring procedure as being outside the reference cluster (RC), using a distance of said vector (VR) from the reference cluster (RC), such that:
a proportional contribution of the change speeds (vj(ti)) of the measured values (mj(ti)) of the measured variable (Mj) to the distance of the vector (VR) from the reference cluster (RC) is determined for each measured variable (Mj), and
the measured values (mj(ti)) of the measured variable(s) (Mj) whose proportional contribution has the largest value and/or exceeds a predefined limit value is determined as the at least one anomaly cause, and
information is provided about the at least one anomaly cause.

12. Procedure as claimed in Claim 11, wherein, on the basis of at least one anomaly cause previously determined, the cause of the anomaly determined using the monitoring procedure is determined by checking whether the anomaly detected by the monitoring procedure has been caused by a chronological variation, which deviates from a target behavior, of at least one of the measured variables (Mj) identified by means of the anomaly causes or by a functional impairment of the measuring device (MDj) measuring the respective measured variable (Mj) by checking a measuring accuracy of the measuring devices (MDj) identified by means of the anomaly causes.

13. Procedure as claimed in Claim 12, wherein the training data (DT) are collected during a training period in which the error-free operation of the system and the measuring devices (MDj) can be assumed and in which the process is performed several times in succession.

## Revendications

1. Procédé destiné à la surveillance de grandeurs de mesure (Mj) mesurées en continu sur une installation de technique des process pendant l'exécution répétée d'un process dynamique prédéfini avec un groupe d'appareils de mesure (MDj) utilisés sur l'installation et variant dans le temps pendant les process, procédé pour lequel :
pendant les exécutions répétées du process dynamique, on enregistre en continu des données de mesure (D) qui comprennent des valeurs de mesure (mj(ti)) des grandeurs de mesure (Mj) mesurées au moyen des appareils de mesure (MDj) et les temps de mesure (ti) correspondants auxquels les valeurs de mesure (mj(ti)) ont été mesurées,
les données de mesure (D) comprenant des données d'apprentissage (DT) mesurées au cours d'une période d'apprentissage et des données de surveillance (DU) mesurées à la suite de la période d'apprentissage,
on détermine en continu, à l'aide des données de mesure (D), des vecteurs (VR) dont les composantes vectorielles comprennent respectivement, pour une série de k instants successifs ([tr1, ..., trk]), des vitesses de variation (vj(ti)) des valeurs de mesure (mj(ti)) des différentes grandeurs de mesure (Mj), lesquelles vitesses de variation sont déterminées à l'aide des données de mesure (D), les instants ([tr1, ..., trk]) de chaque série couvrant respectivement une fenêtre temporelle de durée prédéfinie (ΔT) et les fenêtres temporelles de vecteurs (VR) successifs étant décalées les unes par rapport aux autres respectivement d'une différence temporelle prédéfinie,
les vecteurs (VR) déterminés à l'aide des données d'apprentissage (DT) sont saisis et mémorisés sous la forme d'un cluster de référence (RC), et
un procédé de surveillance est exécuté, au cours duquel :
les vecteurs (VR) déterminés à l'aide des données de surveillance (DU) sont respectivement comparés avec le cluster de référence (RC),
une anomalie est constatée lorsqu'au moins l'un des vecteurs (VR) déterminés à l'aide des données de surveillance (DU) se trouve en dehors du cluster de référence (RC), et
une information sur l'anomalie constatée est mise à disposition.

2. Procédé selon la revendication 1, pour lequel :
la saisie des données de mesure (D) s'effectue de telle sorte que les valeurs de mesure (mj(ti)) des grandeurs de mesure (Mj) et les temps de mesure (ti) correspondants sont transmis à un dispositif de traitement de données (11) et sont stockés au moins temporairement dans une mémoire (13) associée au dispositif de traitement de données (11), et
le dispositif de traitement de données (11) est conçu pour exécuter, à l'aide des données de mesure (D), la détermination des vecteurs (VR), la détermination du cluster de référence (RC) et le procédé d'observation, et lequel dispositif est conçu pour émettre l'information concernant l'anomalie constatée par l'intermédiaire d'une interface (19) raccordée au dispositif de traitement de données (11) et/ou pour la mettre à disposition sous une forme pouvant être lue et/ou appelée par l'intermédiaire de l'interface (19).

3. Procédé selon les revendications 1 à 2, pour lequel la durée prédéfinie (ΔT) des fenêtres temporelles :
est inférieure ou égale à une durée du process,
est supérieure ou égale à une durée d'au moins un événement de process dynamique survenant pendant chaque exécution du process et faisant varier dans le temps au moins deux des grandeurs de mesure (Mj),
est supérieure ou égale à au moins un temps de réaction associé respectivement à l'une des grandeurs de mesure (Mj), temps avec lequel les valeurs de mesure (mj(ti)) de la grandeur de mesure (Mj) respective se modifient en réaction à un événement de process dynamique, et/ou
est supérieure ou égale à au moins une échelle de temps associée respectivement à l'une des grandeurs de mesure (Mj), échelle sur laquelle les valeurs de mesure (mj(ti)) de la grandeur de mesure (Mj) respective se modifient dans le temps.

4. Procédé selon les revendications 1 à 3, pour lequel la durée prédéterminée (ΔT) des fenêtres temporelles est déterminée à l'aide des données d'apprentissage (TD), en ce que :
à l'aide des vitesses de variation (vj(ti)) des valeurs de mesure (mj(ti)) de l'une des grandeurs de mesure (Mj), on détermine un instant de début (ta) auquel les vitesses de variation (vj(ti)) des valeurs de mesure (mj(ti)) de cette grandeur de mesure (Mj) dépassent une valeur limite prédéfinie,
à l'aide des valeurs de mesure (mj(ti)) des autres grandeurs de mesure (Mj), on détermine pour chacune des autres grandeurs de mesure (Mj) un instant de fin (tej) spécifique à la grandeur de mesure, instant auquel les vitesses de variation (vj(ti)) des valeurs de mesure (mj(ti)) de l'autre grandeur mesurée (Mj) respective dépassent pour la première fois une valeur limite prédéfinie après l'instant de départ (ta),
on détermine, pour chaque grandeur mesurée (Mj), respectivement une différence (Δtj := tej -ta) entre l'instant de fin (tej) spécifique à la grandeur mesurée et l'instant de départ (ta), et
on détermine la durée (ΔT) des fenêtres temporelles de telle sorte qu'elle soit supérieure ou égale à au moins une de ces différences (Δtj := tej -ta).

5. Procédé selon les revendications 1 à 4, pour lequel la durée prédéfinie (ΔT) des fenêtres temporelles est déterminée à l'aide des données d'apprentissage (DT), en ce que :
pour au moins une des grandeurs mesurées (Mj) respectivement :
à l'aide des vitesses de variation (vj(ti)) des valeurs de mesure (mj(ti)) de la grandeur de mesure (Mj) respective, on détermine des périodes dans lesquelles les valeurs de mesure (mj(ti)) de la grandeur de mesure (Mj) respective varient dans le temps et on détermine une valeur moyenne des vitesses de variation (vj(ti)) apparaissant dans ces périodes, et
on détermine une échelle de temps qui correspond à une période, dans laquelle les valeurs de mesure (mj(ti)) de cette grandeur de mesure (Mj) varient, pour une vitesse de variation (vj(ti)) correspondant à la valeur moyenne, d'une proportion prédéfinie, d'une proportion supérieure ou égale à 40 % ou d'une proportion supérieure ou égale à 60 % d'une gamme de mesure de l'appareil de mesure (MDj) mesurant la grandeur de mesure (Mj) respective, et
la durée (ΔT) des fenêtres temporelles est déterminée de telle sorte qu'elle soit supérieure ou égale à au moins une de ces échelles de temps.

6. Procédé selon les revendications 1 à 5, pour lequel les intervalles de temps entre les instants successifs (tr1, ..., trk) à l'intérieur des fenêtres temporelles sont chacun égaux à un temps de discrétisation constant prédéfini.

7. Procédé selon la revendication 6, pour lequel le temps de discrétisation est tel qu'il est suffisamment petit pour pouvoir résoudre une dynamique du process.

8. Procédé selon les revendications 6 à 7, pour lequel le temps de discrétisation est déterminé à l'aide des données d'apprentissage (TD), en ce que :
pour au moins une des grandeurs mesurées (Mj) respectivement :
à l'aide des vitesses de variation (vj(ti)) des valeurs de mesure (mj(ti)) de la grandeur de mesure (Mj) respective, on détermine des périodes dans lesquelles les valeurs de mesure (mj(ti)) varient dans le temps et on détermine une valeur moyenne des vitesses de variation (vj(ti)) apparaissant dans ces périodes, et
on détermine une échelle de temps qui correspond à une période, dans laquelle les valeurs de mesure (mj(ti)) de cette grandeur de mesure (Mj) varient, pour une vitesse de variation (vj(ti)) correspondant à la valeur moyenne, d'un pourcentage prédéfini, d'un pourcentage inférieur ou égal à 10 % ou d'un pourcentage inférieur ou égal à 5 % d'une gamme de mesure de l'appareil de mesure (MDj) mesurant la grandeur de mesure (Mj) respective, et
on détermine le temps de discrétisation de telle sorte qu'il soit inférieur ou égal à au moins une de ces échelles de temps.

9. Procédé selon les revendications 6 à 8, pour lequel la différence de temps, dont les fenêtres temporelles de vecteurs (VR) successifs sont décalées dans le temps les unes par rapport aux autres, est supérieure au temps de discrétisation et/ou est inférieure ou égale à la durée (ΔT) des fenêtres temporelles.

10. Procédé selon les revendications 1 à 9, pour lequel une cause de l'anomalie détectée par le procédé de surveillance est déterminée et/ou corrigée par une contre-mesure correspondante.

11. Procédé selon la revendication 10, pour lequel, pour au moins un vecteur (VR) identifié à l'aide du procédé de surveillance comme étant situé en dehors du cluster de référence (RC), on détermine au moins une cause d'anomalie à l'aide d'une distance de ce vecteur (VR) par rapport au cluster de référence (RC), en ce que :
pour chaque grandeur mesurée (Mj), on détermine respectivement une contribution proportionnelle des vitesses de variation (vj(ti)) des valeurs de mesure (mj(ti)) de la grandeur mesurée (Mj) respective à la distance du vecteur (VR) par rapport au cluster de référence (RC), et
on détermine comme l'au moins une cause d'anomalie les valeurs de mesure (mj(ti)) de la/des grandeur(s) de mesure (Mj) dont la contribution proportionnelle présente la plus grande valeur et/ou dépasse une valeur limite prédéfinie, et
on met à disposition une information sur l'au moins une cause d'anomalie.

12. Procédé selon la revendication 11, pour lequel on détermine, à l'aide d'au moins une des causes d'anomalies déterminées précédemment, la cause de l'anomalie constatée au moyen du procédé de surveillance, en vérifiant si l'anomalie détectée par le procédé de surveillance a été causée par une variation dans le temps, s'écartant du comportement de consigne, d'au moins une des grandeurs de mesure (Mj) identifiées par l'intermédiaire des causes d'anomalie ou par une altération du fonctionnement de l'appareil de mesure (MDj) mesurant la grandeur de mesure (Mj) respective, en vérifiant une précision de mesure des appareils de mesure (MDj) identifiés par l'intermédiaire des causes d'anomalie.

13. Procédé selon la revendication 12, pour lequel les données d'apprentissage (DT) sont collectées pendant une période d'apprentissage au cours de laquelle on peut supposer que l'installation et les appareils de mesure (MDj) fonctionnent sans erreur, et période au cours de laquelle le process est exécuté plusieurs fois de suite.
